# EUROPÄISCHE PATENTSCHRIFT

(11) **EP 0 521 937 B1**
(45) Veröffentlichungstag und Bekanntmachung des Hinweises auf die Patenterteilung: **07.09.1994**
(21) Anmeldenummer: 91906402.2
(22) Anmeldetag: 19.03.1991
(51) Int. Cl.: H03K 4/83

(54) **SCHALTUNGSANORDNUNG ZUR ERZEUGUNG EINES VERTIKALFREQUENTEN ABLENKSTROMES**
CIRCUIT ARRANGEMENT FOR PRODUCING A VERTICAL FREQUENCY DEFLECTION CURRENT
AGENCEMENT DE CIRCUIT GENERATEUR DE COURANT A LA FREQUENCE DE DEFLECTION VERTICALE

(30) Priorität: 28.03.1990 DE 4009920
(43) Veröffentlichungstag der Anmeldung: 13.01.1993
(73) Patentinhaber: Deutsche Thomson-Brandt GmbH, 78003 Villingen-Schwenningen (DE)
(72) Erfinder: KOBLITZ, Rudolf, D-7730 Vilingen (DE)
(74) Vertreter: Einsel, Robert, Dipl.-Ing.
(86) Internationale Anmeldenummer: EP9100531
(87) Internationale Veröffentlichungsnummer: WO9115057

(56) Entgegenhaltungen:
- EP-A- 30 191
- EP-A- 74 468

## Beschreibung

Die Erfindung betrifft eine Schaltungsanordnung zur Erzeugung eines vertikalfrequenten Ablenkstromes für Elektronenstrahlen in einer Bildröhre eines Fernsehgerätes.

Der Ablenkstrom wird bei modernen Fernsehgeräten mit Hilfe eines D-Verstärkers erzeugt, indem ein durch zeilenfrequente in ihrer Breite modulierte Impulse angesteuerter elektronischer Schalter die Ablenkspulen über den Zeilentransformator periodisch auf Massepotential schaltet. Zur Regelung des Ablenkstromes dient dabei ein Fehlerverstärker, dessen Ausgang mit dem einen Eingang eines Pulsbreiten-Modulators verbunden ist, dessen anderem Eingang ein horizontalfrequentes Sägezahnsignal zugeführt wird. Der Eingang des Fehlerverstärkers liegt in der Brückendiagonalen einer Widerstandbrücke, indem die Eingänge des Fehlerverstärkers über je einen gleichgroßen Widerstand an eine feste Betriebsspannung angeschlossen sind und wobei an die Eingänge andererseits über gleich große Widerstände ein Referenzgleichspannungspotential bzw. ein vertikalfrequentes Sägezahnsignal angelegt sind. Zwischen den mit dem festen Betriebsspannungspotential verbundenen Widerständen ist noch ein sehr niederohmiger Fühlwiderstand geschaltet ( EP 0 074 468 A1). Eine derartige Anordnung hat den Nachteil, daß nicht nur die Brückenwiderstände und der Fehlerverstärker Temperaturdriften ausgesetzt sind, sondern daß auch das DC-Verhalten des horizontalfrequenten Sägezahnsignals und das dynamische Verhalten des Schaltthyristors in die Temperaturstabilität eingeht. Auch die Bauelemente in der Beschaltung besitzen Toleranzen, die sich auf die Stabilität der Schaltung nachteilig auswirken können.

Der Erfindung liegt die Aufgabe zugrunde, derartige Driften und Toleranzen zu eliminieren, so daß die Stabilität der bekannten Schaltungsanordnung auf die thermische Stabilität der Widerstandsbrücke und des Eingangsoffsetverhaltens des Fehlerverstärkers reduziert wird, so daß die Schaltung in integrierter Schaltungstechnik realisierbar wird. Diese Aufgabe wird durch die im Patentanspruch 1 angegebene Maßnahme gelöst. Weitere vorteilhafte Ausgestaltungen der Erfindung ergeben sich aus den abhängigen Ansprüchen.

Nachstehend wird die Erfindung an einem Ausführungsbeispiel mit Hilfe der Zeichnung beschrieben.
Figur 1 zeigt ein erstes Ausführungsbeispiel der Erfindung
Figur 2 zeigt ein zweites Ausführungsbeispiel der Erfindung.

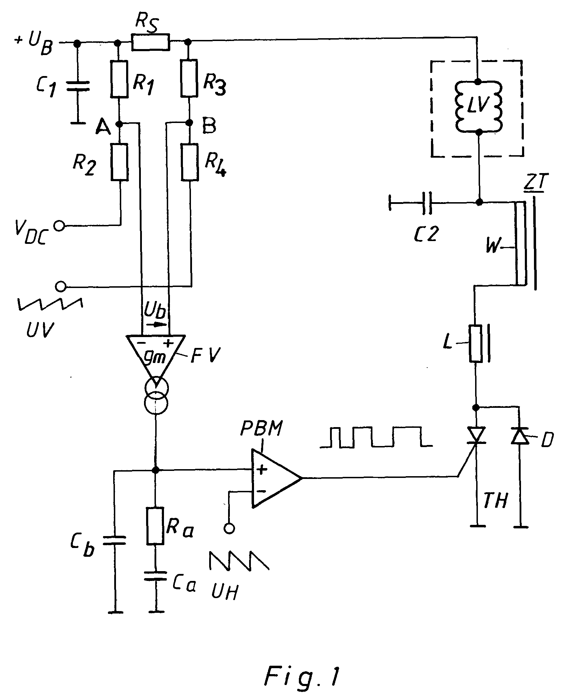

In Figur 1 handelt es sich zunächst um die bekannte Vertikalablenkschaltung, bei der die Vertikalablenkspulen LV einerseits über einen den Ablenkstrom messenden Stromfühlerwiderstand RS an eine Betriebsgleichspannung UB angeschaltet sind und andererseits über eine Wicklung W des Zeilentransformators ZT und eine Induktivität L über den steuerbaren elektronischen Schalter TH periodisch auf Bezugspotential schaltbar sind. Die Verbindung der Vertikalablenkspulen LV mit der Wicklung W des Zeilentransformators ZT ist über eine integrierende Kapazität C2 auf Massepotential geschaltet. Dem elektronischen Schalter TH ist eine Rücklaufdiode D parallelgeschaltet. Der elektronische Schalter TH wird von zeilenfrequenten Impulsen angesteuert, die in ihrer Breite moduliert sind, so daß die Zeiten, in denen die Vertikalablenkspulen LV auf Massepotential liegen, an den Ablenkwinkel angepaßt werden. Die zeilenfrequenten Ansteuerimpulse liefert ein Pulsbreiten-Modulator PBM, der zwei Eingänge besitzt, von denen der eine mit einem horizontalfrequenten Sägezahlsignal UH und der andere mit dem Signal aus einem Fehlerverstärker FV verbunden ist. Der Fehlerverstärker FV besitzt zwei Eingänge, die zwischen die Punkte A und B einer aus den Widerständen R1, R2, R3 und R4 bestehenden Brücke geschaltet sind. Die Widerstände R1, R3 sind mit der Betriebsspannungsquelle UB am Kondensator C1 verbunden, wobei zwischen diesen der Stromfühlerwiderstand RS angeordnet ist. Den beiden anderen Brückenzweigen werden über den Widerstand R2 einerseits ein festes Referenzpotential VDC und über den Widerstand R4 andererseits ein vertikalfrequentes Sägezahnsignal UV zugeführt. Der Fehlerverstärker FV regelt die Breite der Impulse und damit den Ablenkstrom derart, daß die Brückenspannung Ub verschwindet.

Erfindungsgemäß wird hier als Fehlerverstärker FV ein Transkonduktanzverstärker eingesetzt, der die Fähigkeit besitzt, eine ihm zugeführte Eingangsspannung in einen Ausgangsstrom umzuformen. Im Beispiel soll der Transkonduktanzverstärker einen Strom von 1 bis 2 mA pro 1 V Eingangsspannungsänderung liefern, d.h. er besitzt ein gₘ von 1 bis 2 mA/V. An den Ausgang des Transkonduktanzverstärkers ist ein RC-Glied Ra, Ca angeschaltet mit einer derart bemessenen Zeitkonstante, daß in wenigen Zeilen eine vollständige Ausregelung erfolgt. In einem praktisch erprobten Schaltungsaufbau ergab sich ein Ra von 33 kOhm und ein Ca von 15nF. Ein parallel zum RC-Glied Ra, Ca geschalteter Kondensator Cb filtert restliche zeilenfrequente Anteile heraus. Auf diese Weise ist eine Drift des horizontalen Sägezahnsignals sowie die Drift des elektronischen Schalters eliminiert. Der Widerstand Ra des RC-Gliedes Ra, Ca liefert den P-Anteil des PI-Reglers, wodurch auch die Stabilität der Regelung sichergestellt wird.

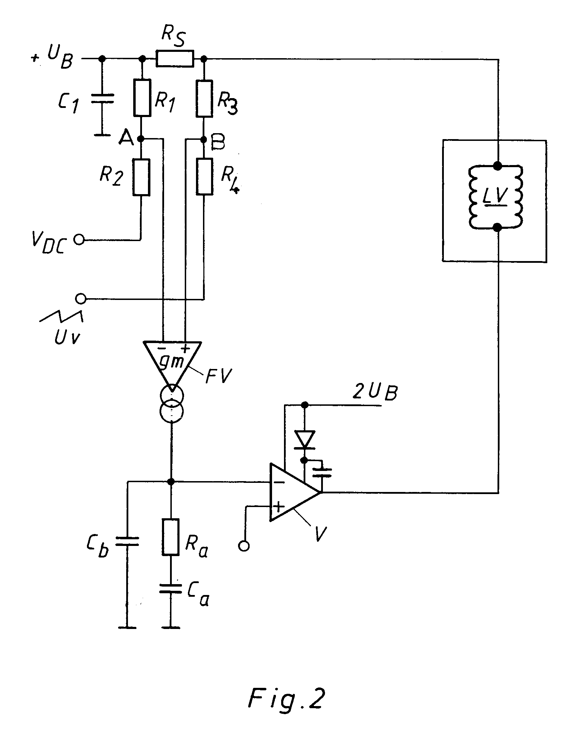

In Figur 2 ist ein weiteres Beispiel für die Anwendung der Erfindung angegeben. Es handelt sich bei der Vertikalendstufe hier um einen Verstärker, der im A-B-Betrieb arbeitet. Hierbei ist der eine (+)-Eingang des Verstärkers V an eine feste Referenzspannung Uref gelegt, an den anderen (-)-Eingang des Verstärkers V ist das Signal aus dem Transkonduktanzverstärker FV geschaltet. Auch bei dieser Anordnung gelten dieselben Betrachtungen hinsichtlich Drift- und Temperaturverhalten wie bei der Anordnung nach Figur 1.

## Patentansprüche

1. Schaltungsanordnung zur Erzeugung eines vertikalfrequenten Ablenkstromes für die Elektronenstrahlen in einer Bildröhre eines Fernsehempfängers mit einem im Ablenkstromkreis angeordneten Stromfühlwiderstand (RS), dessen einem Ende über zwei in Serie geschaltete Widerstände (R1, R2) ein Gleichspannungspotential (DC) und dessen anderem Ende über zwei in Serie geschaltete Widerstände (R3, R4) ein vertikalfrequentes Sägezahnsignal (UV) zugeführt wird, wobei die Verbindungspunkte (A, B) der beiden in Serie geschalteten Widerstände (R1, R2; R3, R4) an die Eingänge eines Fehlerverstärkers (FV) geschaltet sind, dessen Ausgang mit dem Eingang der den Ablenkstrom liefernden Endstufe verbunden ist, **dadurch gekennzeichnet**, daß der Fehlerverstärker (FV) als Transkonduktanzverstärker ausgebildet ist, dessen Ausgang über eine Reihenschaltung eines Widerstandes (Ra) mit einem Kondensator (Ca) mit Bezugspotential verbunden ist.

2. Schaltungsanordnung nach Anspruch 1, **dadurch gekennzeichnet**, daß die den Ablenkstrom liefernde Endstufe aus einem Pulsbreitenmodulator (PBM) mit angeschlossener im D-Betrieb arbeitenden Vertikalendstufe (TH, D) besteht und der Ausgang des Transkonduktanzverstärkers mit dem Eingang des Pulsbreitenmodulators (PBM) verbunden ist.

3. Schaltungsanordnung nach Anspruch 1, **dadurch gekennzeichnet**, daß die den Ablenkstrom liefernde Endstufe als im A-B-Betrieb arbeitende Endstufe ausgebildet ist und der Ausgang des Transkonduktanzverstärkers mit dem Eingang der Vertikalendstufe verbunden ist.

4. Schaltungsanordnung nach den Ansprüchen 1, 2 oder 3, **dadurch gekennzeichnet**, daß die Zeitkonstante (T) des RC-Gliedes (Ra, Ca) in der Größenordnung von mehreren Zeilen liegt.

## Claims

1. Circuit arrangement for generating a vertical frequency deflection current for the electron beams in a picture tube of a television receiver including a current sensing resistor (RS) arranged in the deflection current circuit to whose one end there is supplied a direct voltage potential (DC) via two series connected resistors (R1, R2) and to whose other end there is supplied a vertical frequency sawtooth signal (UV) via two series connected resistors (R3, R4), wherein the connecting point (A, B) of the two series connected resistors (R1, R2; R3, R4) are connected to the inputs of an error amplifier (FV) whose output is connected to the input of the output stage delivering the deflection current, characterised in that, the error amplifier (FV) is constructed as a transconductance amplifier whose output is connected via a series circuit of a resistor (Ra) and a capacitor (Ca) to reference potential.

2. Circuit arrangement in accordance with Claim 1, characterised in that, the output stage delivering the deflection current consists of a pulse width modulator (PBM) having an interconnected vertical output stage working in Class D (TH, D) and the output of the transconductance amplifier is connected to the input of the pulse width modulator (PBM).

3. Circuit arrangement in accordance with Claim 1, characterised in that, the output stage delivering the deflection current is constructed as a power output stage working in Class A-B and the output of the transconductance amplifier is connected to the input of the vertical output stage.

4. Circuit arrangement in accordance with Claims 1, 2 or 3, characterised in that, the time constant (T) of the RC network (Ra, Ca) is in the order of magnitude of several lines.

## Revendications

1. Agencement de circuit générateur d'un courant de déflexion de fréquence verticale pour les faisceaux d'électrons dans un tube image d'un récepteur de télévision avec une résistance à palpeur de courant (RS), placée dans le circuit de déflexion, à l'une des extrémités de laquelle un potentiel de tension continue (DC) est amené par deux résistances (R1, R2) montées en série et à l'autre extrémité de laquelle un signal en dents de scie de fréquence verticale (UV) est amené par deux résistances (R3, R4) montées en série, les points de jonction (A, B) des deux résistances (R1, R2 ; R3, R4) montées en série étant montés aux entrées d'un amplificateur d'erreurs (FV) dont la sortie est reliée à l'entrée de l'étage de sortie qui fournit le courant de déflexion, **caractérisé en ce** que l'amplificateur d'erreurs (FV) est configuré comme un amplificateur à transconductance dont la sortie est reliée au potentiel de référence par un montage en série d'une résistance (Ra) avec un condensateur (Ca).

2. Agencement de circuit selon la revendication 1, **caractérisé en** **ce** que l'étage de sortie qui fournit le courant de déflexion est constitué par un modulateur d'impulsions en largeur (PBM) avec un étage de sortie verticale (TH, D) raccordé qui fonctionne en mode D et la sortie de l'amplificateur à transconductance est reliée à l'entrée du modulateur d'impulsions en largeur (PBM).

3. Agencement de circuit selon la revendication 1, **caractérisé en ce** que l'étage de sortie qui fournit le courant de déflexion est configuré comme un étage de sortie qui fonctionne en service intermittent et la sortie de l'amplificateur à transconductance est reliée à l'entrée de l'étage de sortie verticale.

4. Agencement de circuit selon les revendications 1, 2 ou 3, **caractérisé en ce** que la constante de temps (T) de l'élément RC (Ra, Ca) est de l'ordre de grandeur de plusieurs lignes.
